# EUROPEAN PATENT APPLICATION

(11) **EP 1 403 912 A1**
(43) Date of publication of application: **31.03.2004**
(21) Application number: 02730885.7
(22) Date of filing: 03.06.2002
(51) Int. Cl.: H01L 21/205

(54) **METHOD OF PRODUCING III NITRIDE COMPOUND SEMICONDUCTOR**

(30) Priority: 04.06.2001 JP 2001168015; 04.06.2001 JP 2001168016; 22.05.2002 JP 2002147130
(71) Applicant: Toyoda Gosei Co., Ltd., Nishikasugai-gun, Aichi 452-8564 (JP)
(72) Inventor: KATO, Hisaki, TOYODA GOSEI CO., LTD., Nishikasugai-gun, Aichi 452-8564 (JP); ASAI, Makoto, TOYODA GOSEI CO., LTD., Nishikasugai-gun, Aichi 452-8564 (JP); KANEYAMA, Naoki, TOYODA GOSEI CO., LTD., Nishikasugai-gun, Aichi 452-8564 (JP); SAWAZAKI, Katsuhisa, TOYODA GOSEI CO., LTD., Nishikasugai-gun, Aichi 452-8564 (JP)
(74) Representative: Leson, Thomas Johannes Alois, Dipl.-Ing.
(86) International application number: PCT/JP2002/005446
(87) International publication number: WO 2002/099859

(57) **Abstract**

A Group III nitride compound semiconductor layer 31 having a pit P is formed owing to a small region S (a). Temperature of a substrate is cooled down, supplying material and amount are switched, and then a second Group III nitride compound semiconductor layer 4 having larger aluminum compound is formed. By forming a layer having larger aluminum compound, the small region S which the first Group III nitride compound semiconductor layer 31 cannot cover is covered by the second Group III nitride compound semiconductor layer 4 (b). The bottom part S of the pit is covered by the second Group III nitride compound semiconductor layer 4 through lateral growth, and the first Group III nitride compound semiconductor layer 32 is grown again through epitaxial growth (c). Accordingly, the Group III nitride compound semiconductor layer 32 rapidly grows in a concave part, to thereby obtain a remarkably flat c-plane can be obtained (d).

By temporarily stopping to form a Group III nitride compound semiconductor layer having a pit through epitaxial growth and heating up a substrate to a certain temperature, the surface of the Group III nitride compound semiconductor is activated and a so-called mass transport is generated. Once the bottom part of a pit is covered by the Group III nitride compound semiconductor through lateral growth, a Group III nitride compound semiconductor is formed rapidly on the concave part through epitaxial growth by restarting supplying Group III materials and nitride compound materials.

## Description

### BACKGROUND OF THE INVENTION

### Field of the Invention

The present invention relates to a method for producing a Group III nitride compound semiconductor. As used herein, the term "Group III nitride compound semiconductor" refers to a semiconductor represented by the following formula: AlₓGa_{y}In_{1-x-y}N (0 ≤ x ≤ 1, 0 ≤ y ≤ 1, 0 ≤ x + y ≤ 1), and encompasses two-component semiconductors such as AlN, GaN, and InN; three-component semiconductors such as AlₓGa₁₋ₓN, AlₓIn₁₋ₓN, and GaₓIn₁₋ₓN (in each case, 0 < x < 1); and four-component semiconductors represented by the following formula: AlₓGa_{y}In_{1-x-y}N (0 < x < 1, 0 < y < 1, 0 < x + y < 1). Unless otherwise specified, in the present specification, the term "Group III nitride compound semiconductor" also encompasses Group III nitride compound semiconductors which are doped with an impurity for determining a conduction type of p or n.

### Background Art

Group III nitride compound semiconductors are direct transition type semiconductor, and a light-emitting device formed from a Group III nitride compound semiconductor emits light having a wavelength ranging from ultraviolet to red. Therefore, Group III nitride compound semiconductors have been employed for producing light-emitting devices such as a light-emitting diode (LED) and a laser diode (LD). Since a Group III nitride compound semiconductor has a wide band gap, a device produced from the semiconductor is considered to be operated reliably at high temperature, as compared with a device produced from a semiconductor other than a Group III nitride compound semiconductor. Therefore, applications of Group III nitride compound semiconductors to a variety of transistors, including an FET, have been developed. Since arsenic (As) is not contained in Group III nitride compound semiconductors as a major component thereof, from the environmental viewpoint, use of the semiconductors in a variety of semiconductor elements is envisaged. In general, a Group III nitride compound semiconductor is formed on a sapphire substrate. Also, a Group III nitride compound semiconductor is formed on a silicon carbide (SiC) substrate or a silicon (Si) substrate.

When a Group III nitride compound semiconductor is formed on a substrate by epitaxial growth, in case that the substrate is not perfectly washed or has a microscopic flaw or that growth condition is not optimum, a monocrystal Group III nitride compound semiconductor may not be formed on such soiled surface or flaws of the substrate even when a buffer layer is provided on the substrate. Even when a region having soils or flaws is remarkably small, a region on which the monocrystal Group III nitride compound semiconductor is not formed becomes larger in accordance with forming the Group III nitride compound semiconductor thicker by epitaxial growth. That region is called a pit, which is generated to have a shape of an inverted hexagonal pyramid whose sidewalls are generally {1-101} planes with respect to a Group III nitride compound semiconductor. Each of the sidewalls is inclined about 62° from a growth front of the Group III nitride compound semiconductor when the growth front is a c-plane {0001}. Occasionally, a pit may become as deep as the thickness of the Group III nitride compound semiconductor which is formed by epitaxial growth.

Also, a substrate whose lattice constant or thermal expansion coefficient is close to that of a Group III nitride compound semiconductor may not be obtained at a low price. So a substrate made of different materials such as sapphire, silicon (Si), silicon carbide (SiC), and spinel (MgAl₂O₄) may be used in common. When a Group III nitride compound semiconductor is formed through epitaxial growth on such a substrate made of different materials like sapphire, silicon, SiC and spinel (MgAl₂O₄), however, the Group III nitride compound semiconductor may have an extremely large number of threading dislocations. And those threading dislocations can be starting points of pits described above.

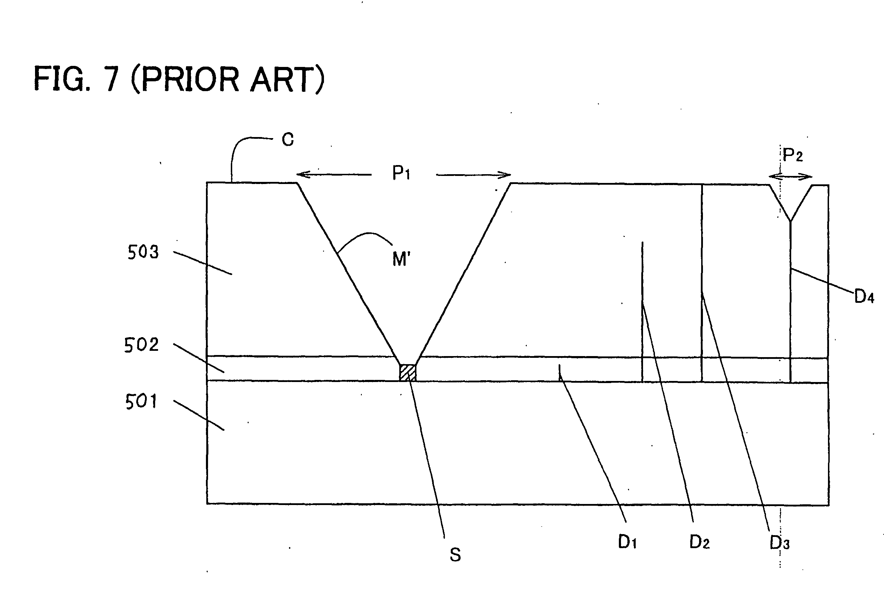

Generation of pits will be described with reference to a representation shown in FIG. 7. FIG. 7 shows a substrate 501, a buffer layer 502 formed on the substrate 501 and a Group III nitride compound semiconductor layer 503 formed on the buffer layer 502. When a small region represented by S formed on the substrate 501 may have a soil or a flaw, the buffer layer 502 may occasionally not cover the region S as shown in FIG. 7. When the Group III nitride compound semiconductor layer 503 is formed on such buffer layer 502 through epitaxial growth in this state, pits P₁ having a {1-101} plane M' which is inclined about 62° from the epitaxial growth front C are generated. This reason is that originally a Group III nitride compound semiconductor may have been deposited and grow on the epitaxial growth front C, but the part having no epitaxial growth front lower cannot grow epitaxially or grows in an extremely slow speed. Owing to difference of lattice constants of the Group III nitride compound semiconductor layer and the substrate 501, threading dislocations D₁, D₂, D₃ and D₄ are generated. These threading dislocations include threading dislocation D₁ which disappears in the growing process of the buffer layer 502, threading dislocation D₂ which disappears in the Group III nitride compound semiconductor layer 503, threading dislocation D₃ which does not disappear in the growing process of the Group III nitride compound semiconductor layer and keeps growing following the growth front C of the Group III nitride compound semiconductor layer 503, and threading dislocation D₄ which generates a pit P₂ at a certain point.

As described above, once pits are generated in a Group III nitride compound semiconductor layer, they never disappear during a conventional epitaxial growth. Also, once pits are generated, device characteristics of a Group III nitride compound semiconductor which is formed on a region having the pits becomes remarkably poor. Also since a Group III nitride compound semiconductor layer has an uneven region even when it is formed by multiple layer film, service life of the device is decreased. The device does not have characteristics as designed. As a result, once pits are generated in a prior art, a Group III nitride compound semiconductor deposited on the layer having those pits may become a defective product and because of that yield rate of the device becomes remarkably poor.

### DISCLOSURE OF THE PRESENT INVENTION

The present invention has been accomplished in an attempt to solve the aforementioned problems, and an object of the present invention is to fabricate a Group III nitride compound semiconductor having less pits through epitaxial growth.

The invention drawn to a first feature provides a method for fabricating a Group III nitride compound semiconductor through epitaxial growth, comprising steps of: a first step in which a first Group III nitride compound semiconductor is grown like a sheet having an uniform thickness through epitaxial growth; a second step in which a second Group III nitride compound semiconductor whose composition is different from those of the first Group III nitride compound semiconductor is formed through epitaxial growth under predetermined conditions that the epitaxial growth is faster in lateral direction than in vertical direction; and a third step in which the first Group III nitride compound semiconductor layer is formed through epitaxial growth, wherein the second Group III nitride compound semiconductor formed through epitaxial growth in the second step covers in a pit generated on the surface of the first Group III nitride compound semiconductor formed in the first step. Here "like a sheet" does not explicitly represent a perfectly flat plane. And "predetermined conditions that the epitaxial growth is faster in lateral direction than in vertical direction" represent a condition that lateral epitaxial growth is faster than vertical epitaxial growth when the Group III nitride compound semiconductor is grown in both lateral and vertical directions at the same time. And covering in pits is not limited to a condition that pits are completely filled and that the surface of the first Group III nitride compound semiconductor becomes smooth, but may also represent a condition that pits are directed to be filled.

A second feature is that the second Group III nitride compound semiconductor grown in the second step comprises aluminum (Al). A third feature is that aluminum composition of Group III material of the second Group III nitride compound semiconductor grown in the second step has molar fraction of 5% or more larger than that of aluminum composition of Group III material of the first Group III nitride compound semiconductor. Here a material having 5% or larger aluminum composition represents, for example, the relationship between GaN and Al_{0.05}Ga_{0.95}N, or the relationship between Al_{0.1}Ga_{0.9}N and Al_{0.15}Ga_{0.85}N in which difference of aluminum composition to all the Group III material is larger than 5% or more. So a material having aluminum composition of 5% or larger does not represent a material whose aluminum composition is larger by 105% or more.

A fourth feature is that aluminum composition of Group III material of the first Group III nitride compound semiconductor has molar fraction of 5% or less and that aluminum composition of Group III material of the second Group III nitride compound semiconductor has molar fraction of 10% or more. A fifth feature is that aluminum composition of Group III material of the first Group III nitride compound semiconductor has molar fraction from 0% to 2% and that aluminum composition of Group III material of the second Group III nitride compound semiconductor has molar fraction of 7% or more.

A sixth feature is that the second step is carried out at the growth temperature of 900°C or more.

A seventh feature provides a method further comprising a step of: at least the first Group III nitride compound semiconductor is etched to be an island-like pattern having a shape of dot, stripe, or grid and a fourth Group III nitride compound semiconductor is formed through vertical and lateral epitaxial growth employing the upper surface of a post and the sidewall of each step of the first Group III nitride compound semiconductor formed in an island-like pattern as a nuclei for crystal growth, following to the third step. Here etching at least the first Group III nitride compound semiconductor is to carry out etching at least the first Group III nitride compound semiconductor grown in the third step. Alternatively, the second Group III nitride compound semiconductor formed in the second step and the first Group III nitride compound semiconductor formed in the first step may also be etched.

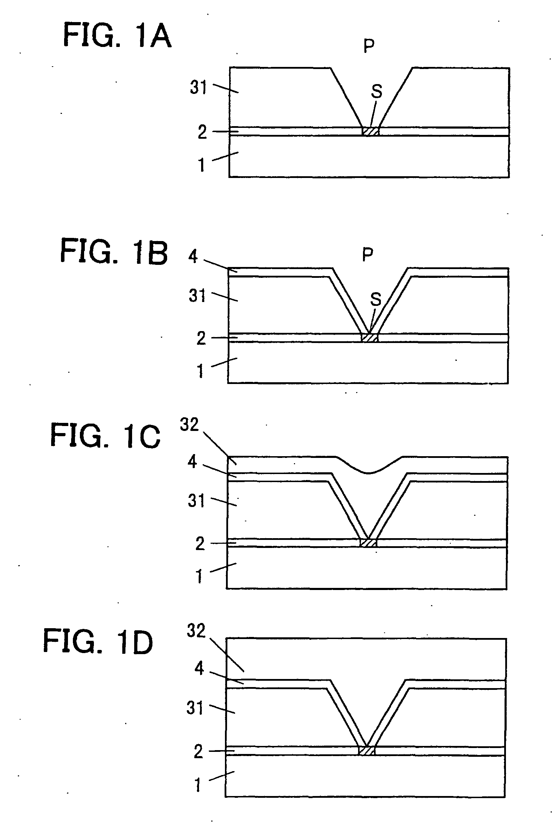

The outline of the first to seventh features of the present invention will next be described with reference to FIGS. 1A-1D. A first Group III nitride compound semiconductor layer 31 having a pit P is formed owing to a small region S (FIG. 1A). Then a second Group III nitride compound semiconductor layer 4 whose compositions are different from those of the first Group III nitride compound semiconductor layer 31 is formed thereon by switching supply material and amount under predetermined conditions. Because the second Group III nitride compound semiconductor layer 4 grows faster in lateral direction than in vertical direction, the second Group III nitride compound semiconductor layer 4 can cover the small region S which the first Group III nitride compound semiconductor layer 31 cannot cover (FIG. 1B). Accordingly, the bottom part (the apex of an inverted hexagonal pyramid) S of the pit P is covered by the second Group III nitride compound semiconductor layer 4 through lateral growth and then a first Group III nitride compound semiconductor layer 32 is formed through epitaxial growth (FIG. 1C). As a result, even if a concave part is left on the second Group III nitride compound semiconductor layer 4, the Group III nitride compound semiconductor layer 32 is rapidly formed thereon, to thereby obtain a remarkably flat c-plane (FIG. 1D and the first feature).

Because the second Group III nitride compound semiconductor layer comprises aluminum, it can easily grow faster in lateral direction (the second feature). Difference of aluminum composition between the first Group III nitride compound semiconductor layer and the second Group III nitride compound semiconductor layer is 5% or more, and further preferably 10% or more (the third feature). When the first Group III nitride compound semiconductor is made of GaN, for example, the inventors of the present invention found that the second Group III nitride compound semiconductor made of Al_{0.1}Ga_{0.9}N or Al_{0.15}Ga_{0.85}N can securely level a pit. When aluminum compound of Group III material in the first Group III nitride compound semiconductor has molar fraction of 5% or less and aluminum compound of Group III material in the second Group III nitride compound semiconductor has molar fraction of 10% or more (the fourth feature), or when aluminum compound of Group III material in the first Group III nitride compound semiconductor has molar fraction from 0% to 2% and aluminum compound of Group III material in the second Group III nitride compound semiconductor has molar fraction of 7% or more (the fifth feature), the present invention can be applied.

When growth temperature in the second step is 900°C or more, the second Group III nitride compound semiconductor can easily grow in lateral direction (the sixth feature). Following to the third step, at least the first Group III nitride compound semiconductor is etched to be an island-like pattern having a shape of dot, stripe, or grid and a fourth Group III nitride compound semiconductor is formed through vertical and lateral epitaxial growth employing the upper surface of the post and the sidewall of each step of the first Group III nitride compound semiconductor formed in an island-like pattern as a nuclei for crystal growth. As a result, through lateral epitaxial growth around a region which has less defects as a nuclei, the region whose step is covered may have a suppressed threading dislocation (the seventh feature).

Alternatively, in the first to seventh features explained above, lateral growth velocity may become faster by doping magnesium in the second Group III nitride compound semiconductor.

The invention drawn to an eighth feature provides a method for fabricating a Group III nitride compound semiconductor on a substrate through epitaxial growth, comprising steps of: a first step in which a first Group III nitride compound semiconductor is grown through epitaxial growth; and a second step in which supplying materials for epitaxial growth is stopped temporarily, the temperature of the substrate is increased by a certain temperature and is kept at a constant temperature, wherein a pit generated on the surface of the first Group III nitride compound semiconductor formed in the first step is covered in the second step. Stopping supplying materials for epitaxial growth temporarily is, for example, to stop supplying at least either one of a Group III material (all of Group III materials if plural) and a nitride compound material. And covering in pits is not limited to a condition that pits are completely filled and that the surface of the first Group III nitride compound semiconductor becomes smooth, but may also represent a condition that pits are directed to be filled.

A ninth feature is that the certain temperature by which the temperature of the substrate is kept in the second step is in a range of 50°C to 200°C.

A tenth feature provides a method further comprising a third step after the second step, in which a Group III nitride compound semiconductor same as that formed in the first step is grown through epitaxial growth. An eleventh feature is that temperature of the substrate in the second step is kept in the third step.

A twelfth feature is that temperature of the substrate in the first step is from 700°C to 1050°C and that temperature of the substrate in the second step after heating up process is from 900°C to 1250°C.

A thirteenth feature provides a method further comprising a fourth step, in which the Group III nitride compound semiconductor substrate formed in the third step is etched to be an island-like pattern having a shape of dot, stripe, or grid and then another Group III nitride compound semiconductor is formed through vertical and lateral epitaxial growth employing the upper surface of the post and the sidewall of each step of the Group III nitride compound semiconductor formed in an island-like pattern as a nuclei for crystal growth. The another Group III nitride compound semiconductor may have the same compositions as those of the Group III nitride compound semiconductor formed in the first and the third steps, or may have compositions a portion of which is different from those of the Group III nitride compound semiconductor formed in the first and the third steps.

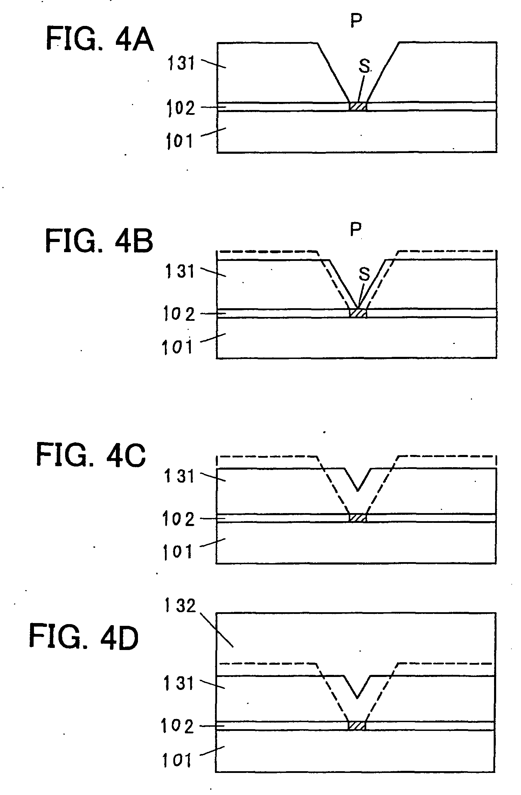

The outline of the eighth to thirteenth features of the present invention will next be described with reference to FIGS. 4A-4D. A Group III nitride compound semiconductor layer 131 having a pit P is formed owing to a small region S (FIG. 4A). Then epitaxial growth is stopped temporarily, temperature of the substrate is raised and kept at a constant temperature. As a result, the surface of the Group III nitride compound semiconductor formed through epitaxial growth is activated and a so-called mass transport is occurred. That is, a portion of the Group III nitride compound semiconductor on which a flat c-plane is formed is caved by a little resolution or migration. On the other hand, the Group III nitride compound semiconductor moves to {1-101} plane in a pit formation part P and grows in lateral direction. The Group III nitride compound semiconductor may moves around the apex of an inverted hexagonal pyramid (the lowest part of the pit P), which prevents epitaxial growth of the Group III nitride compound semiconductor (FIG. 4B). Accordingly, when the Group III nitride compound semiconductor once covers the bottom part (the apex of the inverted hexagonal pyramid) S of the pit through lateral growth (FIG. 4C), even if a concave part is left on the Group III nitride compound semiconductor 131, a Group III nitride compound semiconductor 132 is formed rapidly on the concave part through epitaxial growth by restarting supplying Group III materials and nitride compound materials (FIG. 4D). As a result, a remarkably flat c-plane can be obtained (the eighth feature).

Difference of the temperatures of the substrate in the first step and the second step is preferably from 50°C to 200°C. When difference of the temperatures is less than 50°C, effects of mass transport cannot be obtained. When difference of the temperatures is more than 200°C, it becomes difficult to control so that the Group III nitride compound semiconductor formed in the first step may not grow to be a monocrystalline and a rapid resolution not to contribute mass transport may not occur in the second step (the ninth feature).

Because it is difficult to cover in the pit only by employing mass transport, a Group III nitride compound semiconductor which is same as that formed in the first step may preferably be formed through epitaxial growth following to the second step. As a result, one sequent Group III nitride compound semiconductor, which comprises 3 Group III nitride compound semiconductors each having the same compositions with each other formed in each of the first, the second and the third step, may be obtained (the tenth feature). The temperature of the substrate raised in the second step may preferably kept constant in the third step (the eleventh feature).

In concrete, the temperature of the substrate in the first step may preferably be in a range from 700°C to 1050°C, and may preferably be in a range from 900°C to 1250°C after heating up process in the second step. The temperature of the substrate in both the first and the second steps may preferably be in a range at which a monocrystal can grow (the twelfth feature).

Following to the third step, the Group III nitride compound semiconductor is etched to be an island-like pattern having a shape of dot, stripe, or grid and then another Group III nitride compound semiconductor is formed through vertical and lateral epitaxial growth employing the upper surface of the post and the sidewall of each step of the Group III nitride compound semiconductor formed in an island-like pattern as a nuclei for crystal growth. As a result, through lateral epitaxial growth around a region which has less defects as a nuclei for crystal growth, the region whose step is covered may have a suppressed threading dislocation (the thirteenth feature).

### BRIEF DESCRIPTION OF THE DRAWINGS

FIGS. 1A-1D are cross-sectional views showing steps of a method for producing a Group III nitride compound semiconductor according to a concrete embodiment of the present invention.
FIGS. 2A-2D are cross-sectional views showing steps of a method for producing a Group III nitride compound semiconductor according to other embodiment of the present invention.
FIGS. 3A-3C are cross-sectional views showing some steps of a method for producing a Group III nitride compound semiconductor according to other embodiment of the present invention.
FIGS. 4A-4D are cross-sectional views showing some steps of a method for producing a Group III nitride compound semiconductor according to other embodiment of the present invention.
FIGS. 5A-5D are cross-sectional views showing some steps of a method for producing a Group III nitride compound semiconductor according to other embodiment of the present invention.
FIGS. 6A-6C are cross-sectional views showing some steps of a method for producing a Group III nitride compound semiconductor according to other embodiment of the present invention.
FIG. 7 is a cross-sectional view of a conventional Group III nitride compound semiconductor comprising pits.

### Best Mode for Carrying Out the Invention

Embodiments of the present invention will next be described with reference to the drawings. The present invention is not limited to the below-described specific embodiments, and some part of the description of the present invention may be picked out arbitrary and regardless of other part of the description in order to comprehend the present invention.

Characteristic features of the present invention which have been described above are also preferable mode for carrying out the invention.

On carrying out the present invention, each production embodiment may be chosen from the followings. And the following explanation can be commonly adopted to each of the following embodiment.

When Group III nitride compound semiconductor layers are successively formed on a substrate, the substrate may be formed of an inorganic crystal compound such as sapphire, silicon (Si), silicon carbide (SiC), spinel (MgAl₂O₄), NdGaO₃, LiGaO₂, ZnO, or MgO; a Group III-V compound semiconductor such as gallium phosphide or gallium arsenide; or a Group III nitride compound semiconductor such as gallium nitride (GaN).

A preferred process for forming a Group III nitride compound semiconductor layer is metal-organic chemical vapor deposition (MOCVD) or metal-organic vapor phase epitaxy (MOVPE). However, molecular beam epitaxy (MBE), halide vapor phase epitaxy (halide VPE), or the like may be used. Also, individual layers may be formed by different growth processes.

The present invention is substantially applicable even when the composition of a Group III nitride compound semiconductor is such that a portion of Group III elements are replaced with boron (B) or thallium (Tl) or a portion of nitrogen (N) atoms are replaced with phosphorus (P), arsenic (As), antimony (Sb), or bismuth (Bi). Also, the Group III nitride compound semiconductor may be doped with any one of these elements to such an extent as not to appear in the composition thereof. For example, a Group III nitride compound semiconductor which is represented by AlₓGa₁₋ₓN (0 ≤ x ≤ 1) and which does not contain indium (In) and arsenic (As) may be doped with indium (In), which is larger in atomic radius than aluminum (Al) and gallium (Ga), or arsenic (As), which is larger in atomic radius than nitrogen (N), to thereby improve crystallinity through compensation, by means of compression strain, for crystalline expansion strain induced by dropping off of nitrogen atoms. Through the thus-attained improvement of crystallinity combined with the features of the present invention, threading dislocation can be further reduced to approximately 1/100 to 1/1,000. In the case where a light-emitting device is a target product, use of a binary or ternary Group III nitride compound semiconductor is preferred.

When an n-type Group III nitride compound semiconductor layer is to be formed, a Group IV or Group VI element, such as Si, Ge, Se, Te, or C, can be added as an n-type impurity. A Group II or Group IV element, such as Zn, Mg, Be, Ca, Sr, or Ba, can be added as a p-type impurity. The same layer may be doped with a plurality of n-type or p-type impurities or doped with both n-type and p-type impurities.

Combining with the present invention, the Group III nitride compound semiconductor layer may be formed by employing lateral epitaxial growth. That is, a Group III nitride compound semiconductor layer may be formed by employing various lateral epitaxial growths to decrease threading dislocations in addition to the present invention. The lateral epitaxial growth preferably progresses such that the front of lateral epitaxial growth is perpendicular to a substrate. However, lateral epitaxial growth may progress while slant facets with respect to the substrate are maintained. In this case, trenches may have a V-shaped cross section.

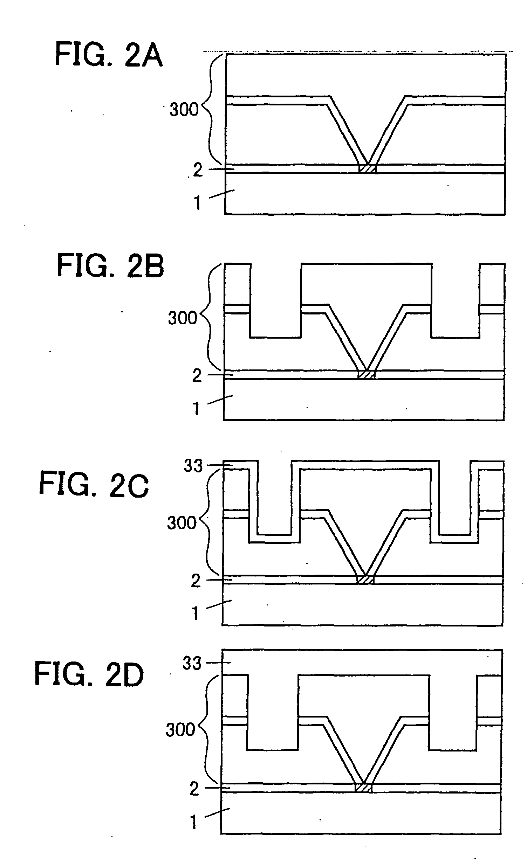

In short, a Group III nitride compound semiconductor layer 300 shown in FIG. 2A, which is formed on a buffer layer 2 provided on a substrate 1 and whose pits are decreased, is etched to be an island-like pattern having a shape of dot, stripe, or grid as shown in FIG. 2B. The Group III nitride compound semiconductor layer 300 comprises a first Group III nitride compound semiconductor layer 31, a second Group III nitride compound semiconductor layer 4 and a third Group III nitride compound semiconductor layer 32 illustrated in FIG. 1D. By growing a fourth Group III nitride compound semiconductor layer 33 through vertical and lateral epitaxial overgrowth employing the upper surface and the sidewall of each step of the Group III nitride compound semiconductor layer 300 as a nuclei (seed) for crystal growth (FIG. 2C), a step is leveled and a region having suppressed threading dislocations at the upper surface of the bottom of the step (FIG. 2D).

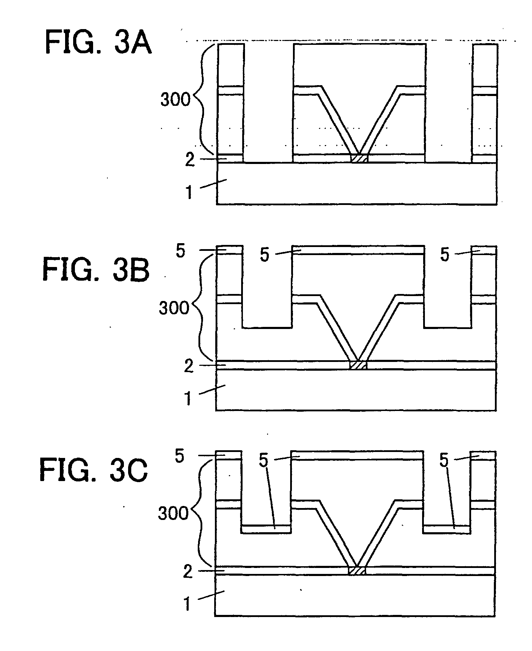

As a method for etching a Group III nitride compound semiconductor layer 300, which is formed on a buffer layer 2 provided on a substrate 1 and whose pits are decreased, to be an island-like pattern having a shape of dot, stripe, or grid, etching until the substrate 1 is exposed as shown in FIG. 3A, covering the upper surface of a post by a mask 5 as shown in FIG. 3B, or covering the upper surface of the post and the bottom surface of a step by a mask 5 as shown in FIG. 3C may be employed.

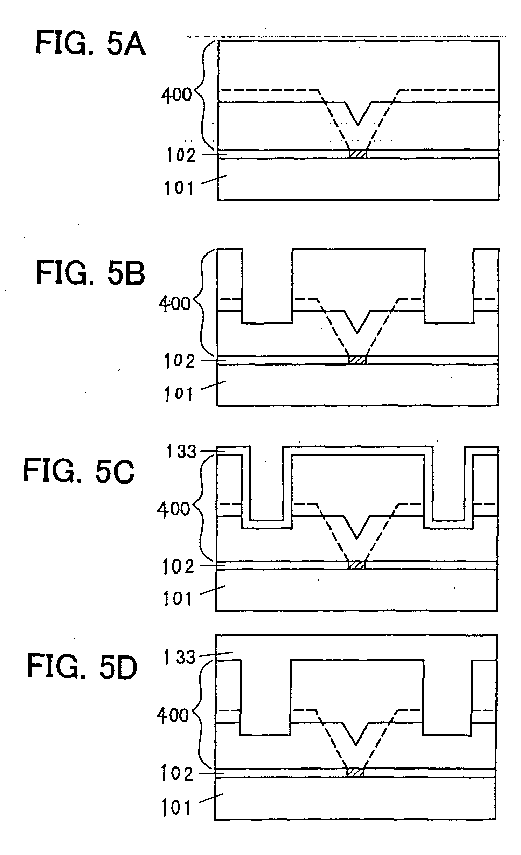

By applying the eighth to thirteenth aspects of the present invention, or by employing a method illustrated in FIGS. 4A-4D, the lateral epitaxial growth shown in FIGS. 5A-5D may be employed. In short, a Group III nitride compound semiconductor layer 400 as shown in FIG. 5A, which is formed on a buffer layer 2 provided on a substrate 1 and whose pits are decreased, is etched to be an island-like pattern having a shape of dot, stripe, or grid as shown in FIG. 5B. The Group III nitride compound semiconductor 400 comprises a Group III nitride compound semiconductor layers 131 and 132 shown in FIG. 4D. By growing a Group III nitride compound semiconductor layer 133 through vertical and lateral epitaxial overgrowth employing the upper surface and the sidewall of each post of the Group III nitride compound semiconductor layer 400 as a nuclei (seed) for crystal growth (FIG. 5C), a step is leveled and a region having suppressed threading dislocations over the bottom of the step is formed (FIG. 5D).

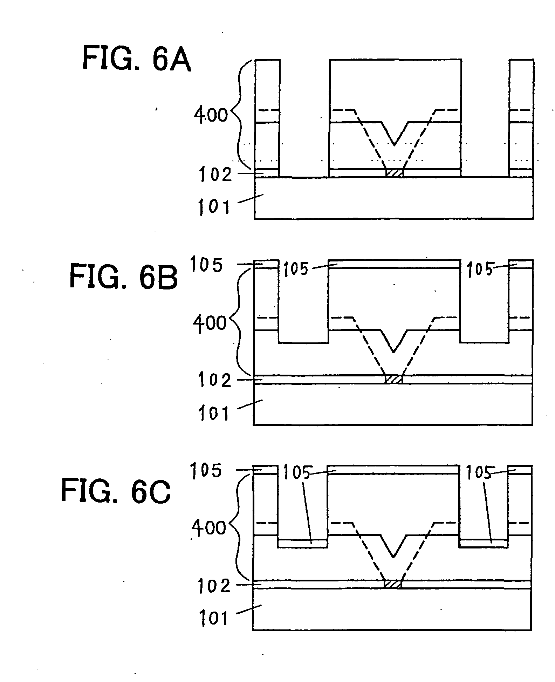

As a method for etching a Group III nitride compound semiconductor layer 400, which is formed on a buffer layer 102 provided on a substrate 101 and whose pits are decreased, to be an island-like pattern having a shape of dot, stripe, or grid, etching until the substrate 101 is exposed as shown in FIG. 6A, covering the upper surface of a post by a mask 105 as shown in FIG. 6B, or covering the upper surface of the post and the bottom surface of a step by a mask 5 as shown in FIG. 6C may be employed.

A semiconductor device such as an FET or a light-emitting device may be formed on a wafer forming the aforementioned Group III nitride compound semiconductor layer containing small amounts of pits. When a light-emitting device is formed, a light-emitting layer may have a multiple quantum well (MQW) structure, a single quantum well (SQW) structure, a homo junction structure, a hetero junction structure, or a double hetero junction structure. The light-emitting layer may contain a pin junction or a pn junction.

A growth temperature of the second Group III nitride compound semiconductor layer is preferably 900°C or higher from a viewpoint of lateral growth. It is because a non-crystal layer may be formed if the growth temperature of the second Group III nitride compound semiconductor is less than 900°C.

Aluminum composition of the second Group III nitride compound semiconductor may preferably be 5% or larger, and more preferably 10% or larger than that of the first Group III nitride compound semiconductor. That is, when the first Group III nitride compound semiconductor is GaN, the second Group III nitride compound semiconductor may be Al_{0.05}Ga_{0.95}N, preferably Al_{0.1}Ga_{0.9}N. By employing the second Group III nitride compound semiconductor whose aluminum composition is larger, the bottom of a pit, which the first Group III nitride compound semiconductor whose aluminum composition is smaller cannot cover, may be covered. And lateral growth of a Group III nitride compound semiconductor may become faster by employing a dopant. By supplying a Group II element functioning as an acceptor, velocity of lateral growth becomes faster even without aluminum. Further, lateral growth of the second Group III nitride compound semiconductor having larger aluminum composition can be faster by doping the group II element.

### [First Embodiment]

The first embodiment is related to a producing method shown in FIGS. 1A-1D. A monocrystalline sapphire substrate 1 containing an *a*-plane as a primary crystal plane was washed with an organic substance and cleaned through heat treatment. The temperature of the substrate 1 was lowered to 400°C, and H₂ (10 L/min), NH₃ (5 L/min), and TMA (20 µmol/min) were fed for about three minutes, to thereby form an AlN buffer layer 2 (thickness: about 20 nm) on the substrate 1. Subsequently, the temperature of the sapphire substrate 1 was maintained at 1100°C, and H₂ (20 L/min), NH₃ (10 L/min), and TMG (300 µmol/min) were fed, to thereby form a GaN layer 31 (thickness: about 1 µm). And, the temperature of the sapphire substrate 1 was cooled to be 1000°C, and H₂ (10 L/min), NH₃ (10 L/min), TMG (100 µmol/min), and TMA (10 µmol/min) were fed, to thereby form an Al_{0.15}Ga_{0.85}N layer 4 (thickness: about 100 nm). Then the temperature of the sapphire substrate 1 was heated to be 1100°C, and H₂ (20 L/min), NH₃ (10 L/min), and TMG (300 µmol/min) were fed, to thereby form a GaN layer 32 (thickness: about 1 µm). Thus-obtained GaN layer 32 has no pits.

### [Comparison Example]

By carrying out similar process to that of the first embodiment, the GaN layer 31 and the GaN layer 32 are formed subsequently, to thereby obtain 6 µm in thickness of GaN layer on an *a*-plane of the sapphire substrate on which the AlN buffer layer is provided. In this example, the substrate is not cooled or heated and the Al_{0.15}Ga_{0.85}N layer 4 is not formed. Thus-obtained GaN layer has several tens of pits par a wafer.

### [Second Embodiment]

In this embodiment, similar process to that of the first embodiment is carried out except that about 100nm in thickness of Al_{0.15}Ga_{0.85}N:Mg is formed in place of the layer 4 which is formed on the GaN 31 having thickness of 1 µm. Doping amount of magnesium (Mg) is about 10¹⁹cm⁻³. Pits are not found in about 5 µm in thickness of GaN layer 32 formed on the layer 4. And it is found that lateral growth rate of the Al_{0.15}Ga_{0.85}N:Mg is faster than that of the Al_{0.15}Ga_{0.85}N.

### [Third Embodiment]

In this embodiment, similar process to that of the first embodiment is carried out except that about 100 nm in thickness of GaN:Mg is formed in place of the layer 4 which is formed on the GaN 31 having thickness of about 1 µm. Doping amount of magnesium (Mg) is about 10¹⁹cm⁻³. Pits are not found on the GaN layer 32 which has thickness of about 5 µm and is formed on the layer 4. And the GaN:Mg is found to grow in lateral direction as opposed to the GaN.

### [Fourth Embodiment]

The fourth embodiment is related to a producing method shown in FIGS. 4A-4D. A monocrystalline sapphire substrate 101 containing an *a*-plane as a primary crystal plane was washed with an organic substance and cleaned through heat treatment. The temperature of the substrate 101 was lowered to 400°C, and H₂ (10 L/min), NH₃ (5 L/min), and TMA (20 µmol/min) were fed for about three minutes, to thereby form an AlN buffer layer 102 (thickness: about 20 nm) on the substrate 101. Subsequently, the temperature of the sapphire substrate 101 was maintained at 1000°C, and H₂ (20 L/min), NH₃ (10 L/min), and TMG (300 µmol/min) were fed, to thereby form a GaN layer 131 (thickness: about 1 µm). And, the temperature of the sapphire substrate 101 was increased to be 1100°C and was maintained for 10 minutes. Then, the temperature of the sapphire substrate 101 was maintained at 1100°C, and H₂ (20 L/min), NH₃ (10 L/min), and TMG (300 µmol/min) were fed, to thereby form a GaN layer 132 (thickness: about 1 µm). Thus-obtained GaN layer 132 has no pits par a wafer.

### [Comparison Example 1]

The temperature of the sapphire substrate 101 was maintained at 1000°C, the GaN layer 131 and the GaN layer 132 were formed subsequently, and, similar to the fourth embodiment, 6 µm in thickness of GaN layer was formed on an *a*-plane of the sapphire substrate 101 on which the AlN buffer layer is provided. Thus-obtained GaN layer has several thousands of pits par a wafer.

### [Comparison Example 2]

The temperature of the sapphire substrate 101 was maintained at 1100°C, and 6 µm in thickness of GaN layer was formed on an *a*-plane of the sapphire substrate 101 on which the AlN buffer layer is provided similar to the comparison example 1. Thus-obtained GaN layer has several tens of pits par a wafer.

While the present invention has been described with reference to the above embodiments as the most practical and optimum ones, the present invention is not limited thereto, but may be modified as appropriate without departing from the spirit of the invention.

## Claims

1. A method for fabricating a Group III nitride compound semiconductor through epitaxial growth, comprising steps of:
a first step in which a first Group III nitride compound semiconductor is grown like a sheet having an uniform thickness through epitaxial growth;
a second step in which a second Group III nitride compound semiconductor whose composition is different from those of said first Group III nitride compound semiconductor is formed through epitaxial growth under predetermined conditions that said epitaxial growth is faster in lateral direction than in vertical direction; and
a third step in which said first Group III nitride compound semiconductor is formed through epitaxial growth,
wherein said second Group III nitride compound semiconductor formed through epitaxial growth in said second step covers in a pit generated on the surface of said first Group III nitride compound semiconductor formed in said first step.

2. A method for fabricating a Group III nitride compound semiconductor according to claim 1, wherein said second Group III nitride compound semiconductor grown in said second step comprises aluminum (Al).

3. A method for fabricating a Group III nitride compound semiconductor according to claim 2, wherein aluminum composition of Group III material of said second Group III nitride compound semiconductor grown in said second step has molar fraction of 5% or more larger than that of aluminum composition of Group III material of said first Group III nitride compound semiconductor.

4. A method for fabricating a Group III nitride compound semiconductor according to claim 2, wherein aluminum composition of Group III material of said first Group III nitride compound semiconductor has molar fraction of 5% or less and aluminum composition of Group III material of said second Group III nitride compound semiconductor has molar fraction of 10% or more.

5. A method for fabricating a Group III nitride compound semiconductor according to claim 2, wherein aluminum composition of Group III material of said first Group III nitride compound semiconductor has molar fraction from 0% to 2% and aluminum composition of Group III material of said second Group III nitride compound semiconductor has molar fraction of 7% or more.

6. A method for fabricating a Group III nitride compound semiconductor according to any one of claims 1 to 5, wherein said second step is carried out at growth temperature of 900°C or more.

7. A method for fabricating a Group III nitride compound semiconductor according to any one of claims 1 to 6, further comprising a step of:
a fourth step in which at least said first Group III nitride compound semiconductor is etched to be an island-like pattern having a shape of dot, stripe, or grid and a fourth Group III nitride compound semiconductor is formed through vertical and lateral epitaxial growth employing the upper surface of a post and the sidewall of each step of said first Group III nitride compound semiconductor formed in an island-like pattern as a nuclei for crystal growth, following to said third step.

8. A method for fabricating a Group III nitride compound semiconductor on a substrate through epitaxial growth, comprising steps of:
a first step in which a first Group III nitride compound semiconductor is grown through epitaxial growth; and
a second step in which supplying materials for epitaxial growth is stopped temporarily, the temperature of said substrate is increased by a certain temperature and is kept at a constant temperature,
wherein a pit generated on the surface of said Group III nitride compound semiconductor formed in said first step is covered in said second step.

9. A method for fabricating a Group III nitride compound semiconductor according to claim 8, wherein said certain temperature by which the temperature of said substrate is increased to be kept in said second step is in a range from 50°C to 200°C.

10. A method for fabricating a Group III nitride compound semiconductor according to any one of claims 8 and 9, further comprising a step of:
a third step in which a Group III nitride compound semiconductor same as that formed in said first step is grown through epitaxial growth, following to said second step.

11. A method for fabricating a Group III nitride compound semiconductor according to claim 10, wherein temperature of said substrate in said second step is kept in said third step.

12. A method for fabricating a Group III nitride compound semiconductor according to any one of claims 8 to 11, wherein temperature of said substrate in said first step is from 700°C to 1050°C and temperature of said substrate in said second step after heating up process is from 900°C to 1250°C.

13. A method for fabricating a Group III nitride compound semiconductor according to any one of claims 10 to 12, further comprising a step of:
a fourth step in which said Group III nitride compound semiconductor formed in said third step is etched to be an island-like pattern having a shape of dot, stripe, or grid and then another Group III nitride compound semiconductor is formed through vertical and lateral epitaxial growth employing the upper surface of a post and sidewall of each step of said Group III nitride compound semiconductor formed in an island-like pattern as a nuclei for crystal growth.

14. A method for fabricating a Group III nitride compound semiconductor according to any one of claims 1 to 7, wherein said second Group III nitride compound semiconductor is doped with magnesium (Mg).
